# EUROPEAN PATENT APPLICATION

(11) **EP 4 788 060 A1**
(43) Date of publication of application: **05.08.2026**
(21) Application number: 24872595.4
(22) Date of filing: 30.09.2024
(51) Int. Cl.: H05B 33/22, G09F 9/30, H05B 33/10, H05B 33/14, H10K 50/115

(54) **DISPLAY DEVICE, NANOMATERIAL, DISPERSION, AND METHOD FOR MANUFACTURING RED DISPLAY DEVICE**

(30) Priority: 29.09.2023 JP 2023170557
(71) Applicant: Toppan Holdings Inc., Tokyo 110-0016 (JP)
(72) Inventor: MIYANAGA, Akiharu, Tokyo 110-0016 (JP); ITO, Tetsuji, Tokyo 110-0016 (JP); WATANABE, Mayuko, Tokyo 110-0016 (JP)
(74) Representative: TBK
(86) International application number: PCT/JP2024/034954
(87) International publication number: WO 2025/070816

(57) **Abstract**

To provide a display device that makes it possible to select a preferred combination of materials for an electron transport layer and a hole transport layer and a method for manufacturing the display device. The present invention is a display device including a display region, wherein the display region includes a light emitting element, in which a first electrode, a light emitting layer, a second electrode, an electron transport layer or a hole transport layer that is formed between the first electrode and the light emitting layer, and a hole transport layer or an electron transport layer that is formed between the second electrode and the light emitting layer are stacked, the electron transport layer contains at least one of ZnO, MgZnO and SnO, and the hole transport layer contains at least one of NiO and MoO.

## Description

### [Technical Field]

The present invention relates to display devices using quantum dots.

### [Background Art]

Patent Literature below discloses an invention that relates to organic EL (organic electroluminescence).

An organic EL element includes an anode, a hole injection layer, a hole transport layer, a light emitting layer, an electron transport layer, an electron injection layer, and a cathode that are stacked on a substrate. Such an organic EL element is formed of an organic compound and emits light due to excitons generated by recombination of electrons and holes injected into the organic compound.

### [Citation List]

### [Patent Literature]

PTL 1: JP 2017-45650 A

### [Summary of the Invention]

### [Technical Problem]

However, the invention disclosed in PTL 1 does not describe anything about a preferred combination of materials for the electron transport layer and the hole transport layer in connection with the absorption edge.

The present invention has been devised in view of this matter, and aims to provide a display device that makes it possible to select a preferred combination of materials for an electron transport layer and a hole transport layer.

### [Solution to Problem]

The present invention is a display device including a display region, wherein the display region includes a light emitting element, in which a first electrode, a light emitting layer, a second electrode, an electron transport layer or a hole transport layer that is formed between the first electrode and the light emitting layer, and a hole transport layer or an electron transport layer that is formed between the second electrode and the light emitting layer are stacked, the electron transport layer contains at least one of ZnO, MgZnO and SnO, and the hole transport layer or a hole injection layer contains at least one of NiO and MoO.

The present invention is a material that is used for an electron transport layer included in the display device, wherein a slope of a Tauc plot of the material at an absorption edge is greater than a slope of a Tauc plot of a bulk material at an absorption edge.

The present invention is a dispersion liquid of the material, wherein the dispersion liquid has a polydispersity index of less than 0.1 in DLS measurement.

### [Advantageous Effects of the Invention]

A display device according to the present invention allows an absorption edge to be steeper using a combination of materials included in an electron transport layer and a hole transport layer.

### [Brief Description of the Drawings]

Fig. 1 is a partial plan view of a display device according to the present embodiment.
Fig. 2 is a partially enlarged cross-sectional view of one enlarged display region of the display device illustrated in Fig. 1.
Fig. 3 is a cross-sectional view of a structure of a thin film transistor different from that of Fig. 2.
Fig. 4A is a cross-sectional view of a light emitting element according to a first embodiment, and Fig. 4B is an energy level diagram of each of layers in a display device according to the first embodiment.
Fig. 5 shows schematic diagrams of a quantum dot according to the present embodiment.
Fig. 6 shows cross-sectional views of a light emitting element according to an embodiment different from that of Fig. 1.
Fig. 7A is an energy level diagram in which a quantum dot having a core-shell structure is used, and Fig. 7B is an energy level diagram in which a quantum dot having a structure in which a core is not covered with a shell is used.
Fig. 8A is a cross-sectional view of another light emitting element different from that of Fig. 4, and Fig. 8B is an energy level diagram of each of layers in the light emitting element of Fig. 8A.
Fig. 9 shows cross-sectional views of a light emitting element according to an embodiment different from that of Fig. 8.
Fig. 10A is an energy level diagram in which a quantum dot having a core-shell structure is used, and Fig. 10B is an energy level diagram in which a quantum dot having a structure in which a core is not covered with a shell is used.
Fig. 11 is a schematic diagram illustrating a step of forming an inorganic layer by an ink-jetting method.
Fig. 12 is a coating photograph according to an Example.
Fig. 13 illustrates PYS measurement data of a Cd-based green quantum dot.
Fig. 14 illustrates PYS measurement data.
Fig. 15 is an energy level diagram of each of layers in a light emitting element used in an experiment.
Fig. 16 is a graph illustrating a relationship between current values of an EL emitter and a PL emitter each including a green quantum dot and EQE.
Fig. 17 is a graph illustrating relationships between current values of an EL emitter and a PL emitter each including a red quantum dot and EQE and further illustrating a relationship between a current value of an EL emitter including a blue quantum dot and EQE.
Fig. 18 includes a graph illustrating an energy band gap Eg, energy E_{CB} at a lower end of a conduction band, and energy E_{VB} at an upper end of a valence band of each of layers in a light emitting element used for an experiment and an energy level diagram of each of the layers.
Fig. 19 illustrates UV data of ZnO_{X}(Li) and ZnO_{X}(K) used for an electron transport layer (ETL).
Fig. 20 illustrates PL data of ZnO_{X}(Li) and ZnO_{X}(K) used for an electron transport layer (ETL).
Fig. 21 illustrates PYS data of ZnO_{X}(Li) and ZnO_{X}(K) used for an electron transport layer (ETL).
Fig. 22 is a synthesis flow of ZnO.
Fig. 23 is a synthesis flow of MgZnO.
Fig. 24 is a synthesis flow of SnOx.
Fig. 25 is a synthesis flow of NiOx.
Fig. 26 is a synthesis flow of MoOx.
Fig. 27A is a graph illustrating a UV spectrum.
Fig. 27B is a graph illustrating band gap energy.
Fig. 28 is a synthesis flow of NiO.
Fig. 29 illustrates XRD for NiO.
Fig. 30 illustrates a UV spectrum of NiO.
Fig. 31 is a graph (Tauc plot) illustrating band gap energy of NiO.
Fig. 32 is an XANES spectrum in an evaluation of Ni valence.
Fig. 33 is a graph illustrating relationships between particle size and scattering intensity distribution in Example 10 to Example 12.

### [Description of the Embodiments]

In the following description, one embodiment of the present invention (hereinafter, also referred to as an "embodiment") will be described in detail. The present invention is not limited to the following embodiment, and various modifications can be made within the scope of the present invention.

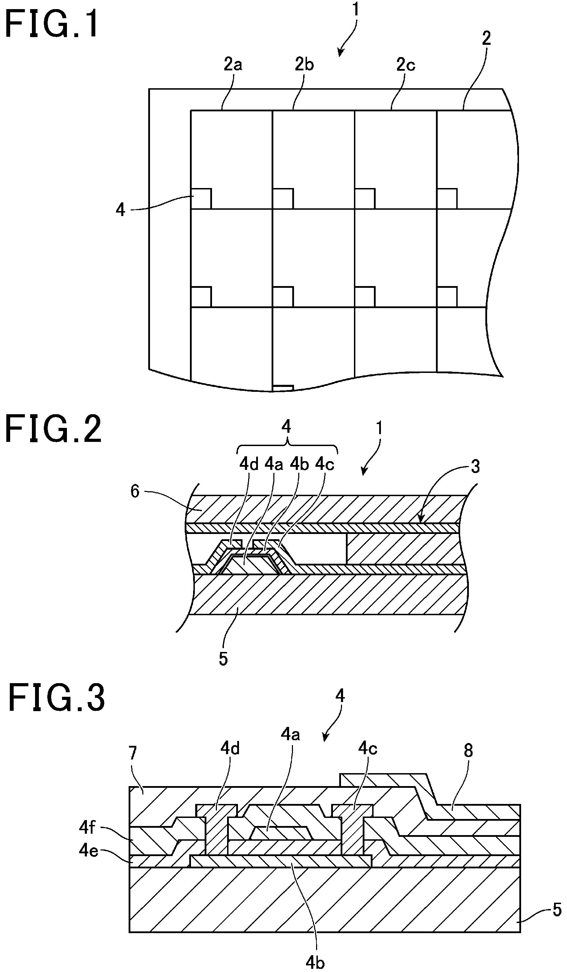

As illustrated in Fig. 1, a display device 1 includes a plurality of display regions 2 arranged in a matrix. The display regions 2 include three types: a red light emitting region 2a that emits red light, a green light emitting region 2b that emits green light, and a blue light emitting region 2c that emits blue light. These three light emitting regions 2a, 2b, and 2c may be arranged as one set, for example, in the row direction and constitute one pixel in color display.

A light emitting element 3 is formed in each of the light emitting regions 2a, 2b, and 2c. The layer structure of the light emitting element 3 will be described below. A thin film transistor (TFT) 4 is connected to each light emitting element 3. The light emitting element 3 may be, for example, a top-emission type.

The thin film transistor 4 illustrated in Fig. 2 is an n-ch TFT and includes a gate electrode 4a, a channel layer 4b, a gate insulating film (not illustrated), a drain electrode 4c, a source electrode 4d, and the like that are stacked on a substrate 5. Although the material of the channel layer 4b is not limited, it is an N-type semiconductor and an oxide semiconductor is preferably used. An In-Ga-Zn-O-based semiconductor is preferably used as the oxide semiconductor. The In-Ga-Zn-O-based semiconductor has high mobility and a low leak current and is favorably usable as the thin film transistor. In addition, Poly-Si is also preferably usable. The thin film transistor 4 illustrated in Fig. 2 is a top-contact bottom-gate type, but may be a bottom-contact bottom-gate type.

The source electrode 4d is connected to a power supply line and the drain electrode 4c is connected to the light emitting element 3.

The thin film transistor 4 may be a top-gate type thin film transistor illustrated in Fig. 3. As illustrated in Fig. 3, a channel layer 4b is formed on a substrate 5 and the surface of the channel layer 4b is covered with a gate insulating film 4e. Further, a gate electrode 4a is formed on the surface of the gate insulating film 4e. As illustrated in Fig. 3, the surface of the gate electrode 4a is covered with an insulating film 4f. In addition, a plurality of through holes that communicate with the channel layer 4b through the gate insulating film 4e and the insulating film 4f are formed, and a drain electrode 4c and a source electrode 4d are formed through the respective through holes. Furthermore, the surfaces of the drain electrode 4c and the source electrode 4d are covered with a protective film 7. In addition, a transparent electrode that communicates with the drain electrode 4c and the source electrode 4d is formed on the surface of the protective film 7. A transparent electrode 8 illustrated in Fig. 3 communicates with the drain electrode 4c.

The channel layer 4b of the thin film transistor 4 illustrated in Fig. 3 is an N-type semiconductor, and an oxide semiconductor is preferably used. An In-Ga-Zn-O-based semiconductor is preferably used as the oxide semiconductor.

As illustrated in Fig. 2, the display device 1 has a structure in which the thin film transistor 4 and the light emitting element 3 are interposed between the pair of substrates 5 and 6, and a frame-shaped sealing resin (not shown) is provided between the substrates 5 and 6 such that the substrates 5 and 6 are connected to each other via the sealing resin.

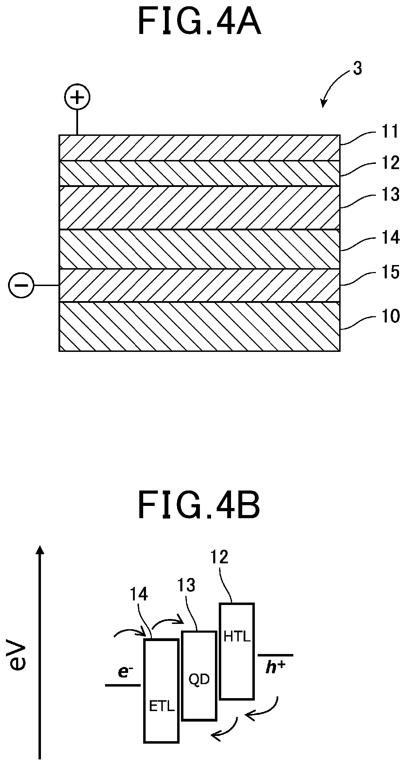

Hereinafter, the structure of the light emitting element 3 will be described. Fig. 4A is a cross-sectional view of a light emitting element according to a first embodiment, and Fig. 4B is an energy level diagram of each of layers in a display device according to the first embodiment.

As illustrated in Fig. 4A, the light emitting element 3 includes a substrate 10, a cathode 15 formed on the substrate, an electron transport layer (ETL) 14 formed on the cathode 15, a light emitting layer (EML: emitter layer) 13 formed on the electron transport layer 14, a hole transport layer (HTL) 12 formed on the light emitting layer 13, and an anode 11 formed on the hole transport layer 12.

When a voltage is applied between the electrodes of the light emitting element 3 of the present embodiment, holes are injected from the anode 11 and electrons are injected from the cathode 15. Fig. 4B illustrates respective energy level models of the hole transport layer 12, the light emitting layer 13, and the electron transport layer 14. As illustrated in Fig. 4B, the holes transported from the hole transport layer 12 are injected from the HOMO level of the hole transport layer 12 to the HOMO level of the light emitting layer 13. Meanwhile, the electrons transported from the electron transport layer 14 are injected from the LUMO level of the electron transport layer 14 to the LUMO level of the light emitting layer 13. The holes and the electrons then recombine in the light emitting layer 13, exciting the quantum dots in the light emitting layer 13, and light can be emitted from the excited quantum dots.

In the present embodiment, the light emitting layer 13 is formed of an inorganic layer containing quantum dots.

### (Quantum Dots)

The configuration and material of the quantum dots are not limited, but the quantum dots according to the present embodiment may be, for example, nanoparticles having a particle size of about several nm to several tens of nm.

For example, the quantum dots may be formed of CdS, CdSe, ZnS, ZnSe, ZnSeS, ZnTe, ZnTeS, InP, (Zn)AgInS₂, (Zn)CuInS₂, or the like. Since the use of Cd is restricted in various countries due to its toxicity, the quantum dots preferably do not contain RoHS restricted substances such as Cd or Pb.

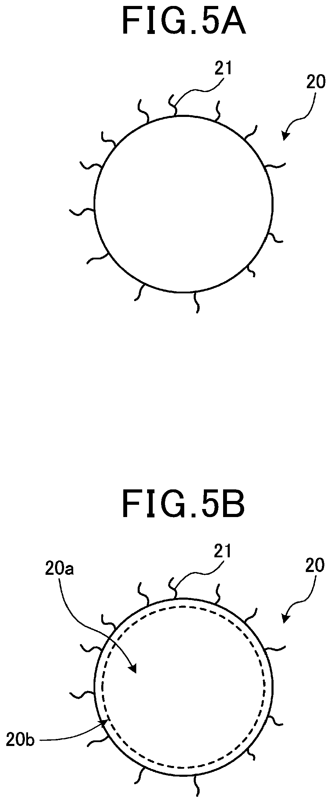

As illustrated in Fig. 5A, a large number of organic ligands 21 are preferably coordinated to the surface of a quantum dot 20. This makes it possible to prevent the quantum dots 20 from aggregating together, thereby exhibiting desired optical characteristics. Ligands usable for a reaction are not limited in particular, and typical examples thereof include the following ligands.

Aliphatic primary amines including oleylamine: C₁₈H₃₅NH₂, stearylamine (octadecylamine): C₁₈H₃₇NH₂, dodecylamine (laurylamine): C₁₂H₂₅NH₂, decylamine: C₁₀H₂₁NH₂, and octylamine: C₈H₁₇NH₂

Fatty acids including oleic acid: C₁₇H₃₃COOH, stearic acid: C₁₇H₃₅COOH, palmitic acid: C₁₅H₃₁COOH, myristic acid: C₁₃H₂₇COOH, lauric acid (dodecanoic acid): C₁₁H₂₃COOH, decanoic acid: C₉H₁₉COOH, and octanoic acid: C₇H₁₅COOH

Thiols including octadecanethiol: C₁₈H₃₇SH, hexadecanethiol: C₁₆H₃₃SH, tetradecanethiol: C₁₄H₂₉SH, dodecanethiol: C₁₂H₂₅SH, decanethiol: C₁₀H₂₁SH, and octanethiol: C₈H₁₇SH

Phosphines including trioctylphosphine: (C₈H₁₇)₃P, triphenylphosphine: (C₆H₅)₃P, and tributylphosphine: (C₄H₉)₃P

Phosphine oxides including trioctylphosphine oxide: (C₈H₁₇)₃P=O, triphenylphosphine oxide: (C₆H₅)₃P=O, and tributylphosphine oxide: (C₄H₉)₃P=O

In addition, it is preferable in the present embodiment to use a short ligand for the organic ligand 21. The organic ligand 21 may be, but is not limited to, 3-mercaptopropionic acid (MPA).

A ligand on each of the quantum dots 20 contained in a quantum dot layer is preferably shorter than a ligand on the quantum dot 20 formed by solution phase synthesis.

In this way, the use of short ligands for ligands on the quantum dots 20 contained in the quantum dot layer makes it possible to decrease the roughness of the quantum dot layer and increase electron and hole extraction efficiency. Meanwhile, by using long ligands for the quantum dots 20 formed by solution phase synthesis, it is possible to increase the dispersibility and film-forming properties.

Alternatively, after the quantum dots 20 having long ligands are synthesized by solution phase synthesis, the long ligands may be replaced with short ligands (e.g., 3-mercaptopropionic acid) before or after a composition containing the quantum dots 20 is applied.

In addition, the quantum dot 20 illustrated in Fig. 5B has a core-shell structure including a core 20a and a shell 20b that coats the surface of the core 20a. As illustrated in Fig. 5B, it is preferable that a large number of organic ligands 21 be coordinated to the surface of the quantum dot 20. The core 20a of the quantum dot 20 illustrated in Fig. 5B is the nanoparticle illustrated in Fig. 5A. Therefore, the core 20a may be formed using, for example, any of the materials described above. Although the material of the shell 20b is not limited, it may be formed of, for example, zinc sulfide (ZnS) or the like. As with the core 20a, the shell 20b preferably does not contain RoHS restricted substances such as cadmium (Cd) or Pb.

It is noted that the shell 20b may be present in solid solution on the surface of the core 20a. Fig. 5B illustrates the boundary between the core 20a and the shell 20b using a dotted line, but this means that it does not matter whether the boundary between the core 20a and the shell 20b can be confirmed by analysis. In addition, although not illustrated, a buffer layer is preferably provided between the core 20a and the shell 20b. The buffer layer is a region in which at least some or all of elements included in the core 20a and at least some or all of elements included in the shell 20b coexist.

### (Light Emitting Layer 13)

The light emitting layer 13 may be formed using the above-described quantum dots alone or may include the quantum dots and other fluorescent substances. In addition, it is possible to form the light emitting layer 13 by applying quantum dots dissolved in a solvent, for example, by an ink-jetting method and there is no problem if solvent components are left in the light emitting layer 13 to some degree.

The light emitting layer 13 of the light emitting element 3 formed in the red light emitting region 2a illustrated in Fig. 1 includes red quantum dots that each emit red fluorescence. In addition, the light emitting layer 13 of the light emitting element 3 formed in the green light emitting region 2b illustrated in Fig. 1 includes green quantum dots that each emit green fluorescence. In addition, the light emitting layer 13 of the light emitting element 3 formed in the blue light emitting region 2c illustrated in Fig. 1 includes blue quantum dots that each emit blue fluorescence.

It is preferable that emitted blue light has a wavelength of about 450 nm. In this way, an adjustment is made to prevent light having a short wavelength of less than 450 nm from being emitted, thereby making it possible to reduce health risks.

It is possible to form the light emitting layer 13 using an existing method for forming a thin film such as the ink-jetting method described above or a vacuum deposition method.

### (Hole Transport Layer 12)

The hole transport layer 12 includes an inorganic substance or an organic substance having a function of transporting holes. The hole transport layer 12 is preferably formed of an inorganic substance, and preferably includes at least one of NiO and MoO. The hole transport layer 12 is particularly preferably formed of nanoparticles of NiO. In addition, it is also possible to mix, for example, Al₂O₃ or the like with NiO in the hole transport layer 12. In addition, a metal oxide may be doped with Li, Mg, Al, or the like. In addition, the hole transport layer 12 may be an inorganic substance other than an inorganic oxide. In the present embodiment, the oxidation deficiency of a metal oxide used for the hole transport layer 12 is preferably less than that of a bulk material.

The "bulk material" refers to a mass including the metal oxide and may have any size and any shape.

It is possible to form the hole transport layer 12 by a printing method such as an ink-jetting method as with the light emitting layer 13 or by an existing thin-film technology such as a vacuum deposition method.

### (Electron Transport Layer 14)

The electron transport layer 14 includes an inorganic substance or an organic substance having a function of transporting electrons. The electron transport layer 14 is preferably formed of an inorganic substance, and preferably includes, for example, at least one of ZnO, MgZnO and SnO. It is also possible to select two or more of them. The electron transport layer 14 is particularly preferably formed of nanoparticles of ZnO_{X}. In addition, a metal oxide may be doped with Li, Mg, Al, Mn, or the like. In addition, the electron transport layer 14 may contain an inorganic substance (e.g., CsPbBr₃ or the like) other than an inorganic oxide. X may be, but is not limited to, about 0.8 to 1.2. In the present embodiment, however, the oxidation deficiency of a metal oxide used for the electron transport layer 14 is preferably less than that of the bulk material.

As with the light emitting layer 13, the electron transport layer 14 can be formed by applying a solvent containing nanoparticles by a printing method such as an ink-jetting method or can be formed by an existing thin-film technology such as a vacuum deposition method.

### (Anode 11)

The material of the anode 11 is not limited in the present embodiment, but it is preferable to form the anode 11 using, for example, a metal such as Au or Ag, an electrically conductive transparent material such as CuISnO₂ or ZnO_{X}, or an indium-tin composite oxide (ITO). Among them, the anode 11 is preferably formed of ITO. It is possible to form a thin film of any of these electrode substances on the substrate 10 as the anode 11 by a method such as vapor deposition or sputtering.

The present embodiment adopts a configuration in which light is extracted from the anode 11 side, and therefore the anode 11 has to be transparent and may preferably be the above-described thin metal film having excellent transparency such as Ag or a metal oxide having excellent transparency.

### (Cathode 15)

The material of the cathode 15 is not limited in the present embodiment, but it is possible to use, for example, an indium-tin composite oxide (ITO), a metal, an alloy, an electrically conductive compound, and a mixture thereof as an electrode substance for the cathode 15. For example, the cathode 15 may be formed of ITO. The cathode 15 may be formed, for example, through a non-transparent metal layer formed on the substrate 10. This makes it possible to use the light emitting element 3 as a top-emission type light emitting element.

It is possible to form a thin film of any of these electrode substances as the cathode 15 by a method such as vapor deposition or sputtering.

### (Substrate 10)

The material of the substrate 10 is not limited in the present embodiment, but it is possible to form the substrate 10 using, for example, glass, plastic, and the like. Specifically, the substrate 10 may be formed of, for example, glass, quartz, and a transparent resin film.

The substrate 10 may be a rigid substrate or a flexible substrate, but the use of a flexible substrate allows the substrate 10 to have flexibility. The transparent resin film may be, for example, polyester such as polyethylene terephthalate (PET) or polyethylene naphthalate (PEN), polyethylene, polypropylene, cellophane, cellulose diacetate, cellulose triacetate (TAC), or the like.

In the display device 1 illustrated in Fig. 2, the use of flexible substrates for both the substrates 5 and 6 allows the display device 1 to have flexibility. It is also possible to form the substrates 5 and 6 using materials similar to that of the substrate 10. The substrate 5 can also serve as the substrate 10.

In the present embodiment, all the layers from the cathode 15 to the anode 11, that is, the cathode 15, the electron transport layer 14, the light emitting layer 13, the hole transport layer 12, and the anode 11, can all be formed of inorganic layers. By forming all the layers as inorganic layers as described above, film formation can be performed using the same coating and drying apparatus or the like, thereby simplifying the manufacturing step. In addition, it is possible to optimize the relative magnitudes of the HOMO levels from the anode 11 to the hole transport layer 12 and the light emitting layer 13 and optimize the relative magnitudes of the LUMO levels from the cathode 15 to the electron transport layer 14 and the light emitting layer 13, improving the carrier balance compared to the case where an organic compound is used.

In the first embodiment illustrated in Fig. 4, the hole injection layer and the electron injection layer are not formed separately from the transport layers, and the number of layers can be reduced. That is, the transport layer can also serve as the injection layer. However, in the present embodiment, it is also possible to interpose a hole injection layer or an electron injection layer including an inorganic material between each electrode and each transport layer.

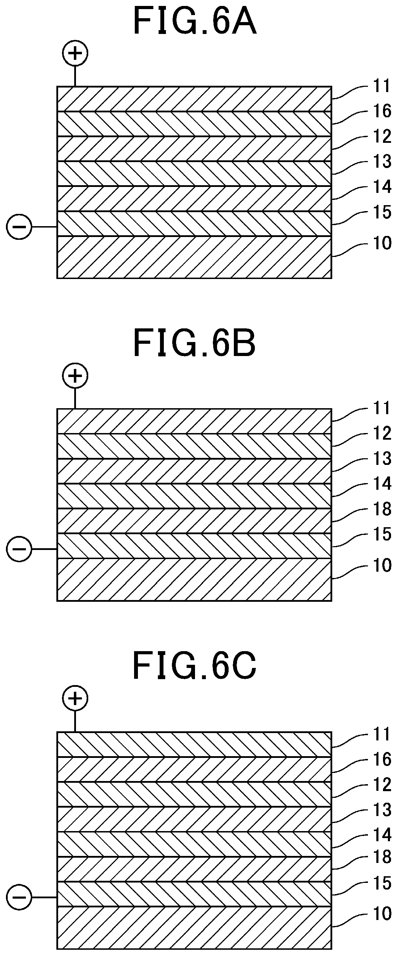

Fig. 6A is a cross-sectional view of a light emitting element according to a second embodiment. In Fig. 6A, the cathode 15, the electron transport layer 14, the light emitting layer 13, the hole transport layer 12, a hole injection layer (HIL) 16, and the anode 11 are stacked on the substrate 10 in this order. In Fig. 6A, unlike Fig. 4A, the hole injection layer 16 is included between the anode 11 and the hole transport layer 12.

Fig. 6B is a cross-sectional view of a light emitting element according to a third embodiment. In Fig. 6B, the cathode 15, an electron injection layer (EIL) 18, the electron transport layer 14, the light emitting layer 13, the hole transport layer 12, and the anode 11 are stacked on the substrate 10 in this order. In Fig. 6B, unlike Fig. 4A, the electron injection layer 18 is included between the electron transport layer 14 and the cathode 15.

Fig. 6C is a cross-sectional view of a light emitting element according to a fourth embodiment. In Fig. 6C, the cathode 15, the electron injection layer 18, the electron transport layer 14, the light emitting layer 13, the hole transport layer 12, the hole injection layer 16, and the anode 11 are stacked on the substrate 10 in this order. In Fig. 6C, unlike Fig. 4A, the hole injection layer 16 is included between the anode 11 and the hole transport layer 12, and the electron injection layer 18 is included between the electron transport layer 14 and the cathode 15.

The materials of the hole injection layer 16 and the electron injection layer 18 are not limited, and may be an inorganic substance or an organic substance, but forming the hole injection layer 16 and the electron injection layer 18 as inorganic layers is preferred because all the layers from the anode 11 to the cathode 15 can be formed of inorganic layers. Various materials are selected for the hole injection layer 16 and the electron injection layer 18 on the basis of the energy level models.

It is preferable in the present embodiment that a layer between the cathode 15 and the light emitting layer 13 be the electron transport layer 14, the electron injection layer 18, a layer serving as both an electron injection layer and an electron transport layer, or a layer in which the electron transport layer 14 and the electron injection layer 18 are stacked.

It is preferable in the present embodiment that a layer between the anode 11 and the light emitting layer 13 be the hole transport layer 12, the hole injection layer 16, a layer serving as both a hole injection layer and a hole transport layer, or a layer in which the hole transport layer 12 and the hole injection layer 16 are stacked.

In the case of the structure of the display device 1 illustrated in Fig. 2, the thin film transistor 4 may be, for example, a bottom-gate type, and the drain electrode 4c is connected to the cathode 15 of the light emitting element 3. In this case, it is possible to cause the drain electrode 4c to serve as the cathode 15 instead of overlaying and forming the cathode 15 on the drain electrode 4c. This makes it possible to appropriately connect the light emitting element 3 to the thin film transistor 4 and a grounding line.

In the present embodiment, the hole transport layer 12, the light emitting layer 13, and the electron transport layer 14 can all be inorganic layers formed of nanoparticles. In this case, it is possible to print and form the respective layers by an ink-jetting method or the like and easily form the respective layers at uniform film thickness. This makes it possible to effectively increase the light emission efficiency.

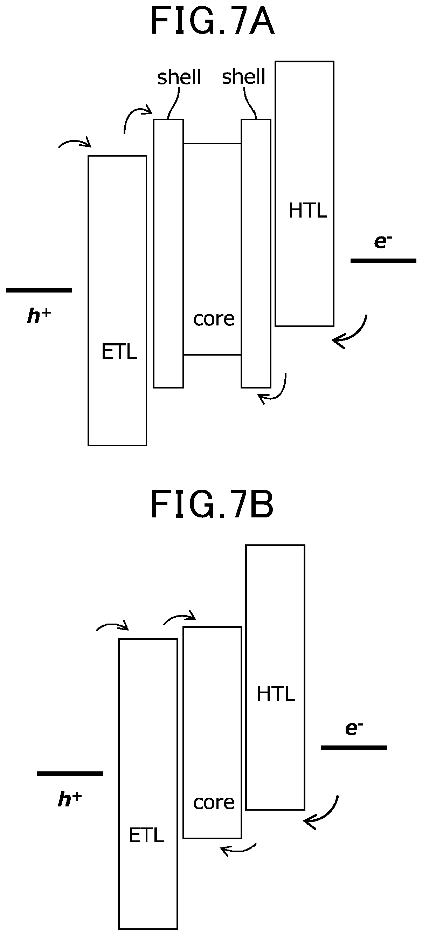

When quantum dots used for the light emitting layer 13 according to the present embodiment each have a core-shell structure, the energy level diagram illustrated in Fig. 7A is obtained. The energy level of the shell can serve as a recombination barrier for holes and electrons. It is therefore preferable to use quantum dots in each of which the surface of the core is not covered with a shell (the surface of the core is exposed: the material included in a quantum dot is uniform from the center of the quantum dot to the surface) as illustrated in Fig. 7B. The use of such quantum dots eliminates an energy barrier for the recombination of holes and electrons. It is possible to efficiently recombine holes and electrons and increase the light emission efficiency. Additionally, to increase the electron transport efficiency and the hole transport efficiency, it is preferable to coordinate the organic ligands 21 to the surface of the quantum dot 20 as illustrated in Fig. 5A.

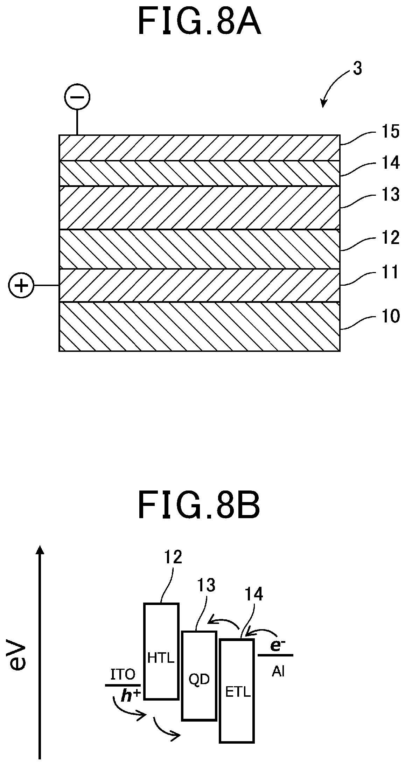

In addition, in the present embodiment, as illustrated in Fig. 8A, the light emitting element 3 may include the substrate 10, an anode 11 formed on the substrate, an electron transport layer (HTL) 12 formed on the anode 11, the light emitting layer (EML: emitter layer) 13 formed on the hole transport layer 12, the electron transport layer (ETL) 14 formed on the light emitting layer 13, and the cathode 15 formed on the electron transport layer 14.

The materials of each of the layers are as described above. However, in Fig. 8A, the anode 11 constitutes a first electrode and the cathode 15 constitutes a second electrode. The light emitting element 3 according to the present embodiment is a top-emission type. It is thus preferable to form the anode 11 using an extremely thin transparent material such as Ag and form the cathode 15 using, for example, an ITO on a non-transparent metal layer. This makes it possible to reflect light on the cathode 15 and extract light from the front surface side (opposite to the thin film transistor) closer to the anode 11.

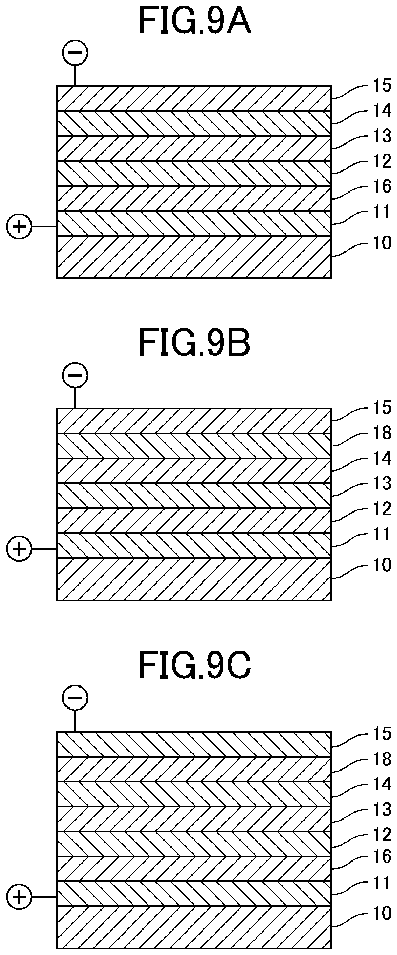

Fig. 9A is a cross-sectional view of a light emitting element according to an embodiment different from that of Fig. 8A. In Fig. 9A, the anode 11, the hole injection layer (HIL) 16, the hole transport layer 12, the light emitting layer 13, the electron transport layer 14, and the cathode 15 are stacked on the substrate 10 in this order. In Fig. 9A, unlike Fig. 8A, a hole injection layer 16 is included between the anode 11 and the hole transport layer 12.

Fig. 9B is a cross-sectional view of a light emitting element according to an embodiment different from that of Fig. 8A. In Fig. 9B, the anode 11, the hole transport layer 12, the light emitting layer 13, the electron transport layer 14, the electron injection layer (EIL) 18, and the cathode 15 are stacked on the substrate 10 in this order. In Fig. 9B, unlike Fig. 8A, the electron injection layer 18 is included between the electron transport layer 14 and the cathode 15.

Fig. 9C is a cross-sectional view of the light emitting element according to the fourth embodiment. In Fig. 9C, the anode 11, the hole injection layer 16, the hole transport layer 12, the light emitting layer 13, the electron transport layer 14, the electron injection layer 18, and the cathode 15 are stacked on the substrate 10 in this order. In Fig. 9C, unlike Fig. 8A, the hole injection layer 16 is included between the anode 11 and the hole transport layer 12, and the electron injection layer 18 is included between the electron transport layer 14 and the cathode 15.

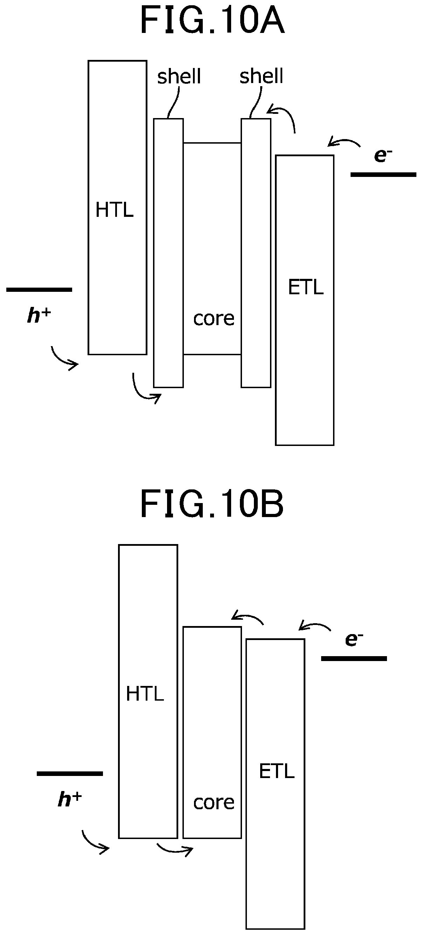

When quantum dots used for the light emitting layer 13 illustrated in Figs. 8 and 9 each have a core-shell structure, the energy level diagram illustrated in Fig. 10A is obtained. The energy level of the shell can serve as a recombination barrier for holes and electrons. Therefore, as illustrated in Fig. 10B, the use of quantum dots in each of which the shell does not coat the surface of the core eliminates an energy barrier for the recombination of holes and electrons. It is possible to efficiently recombine holes and electrons and increase the light emission efficiency. Additionally, to increase the electron transport efficiency and the hole transport efficiency, it is preferable to coordinate the organic ligands 21 to the surface of the quantum dot 20 as illustrated in Fig. 5A.

The light emitting element according to an embodiment illustrated in Figs. 8 and 9 is a Conventional EL and the light emitting element according to an embodiment in Figs. 4 and 6 has a configuration obtained by conversely stacking the Conventional EL. It is preferable to use a p-ch TFT as a thin film transistor in the light emitting element according to the embodiment illustrated in Figs. 8 and 9. It is thus preferable to form a channel layer using a P-type semiconductor.

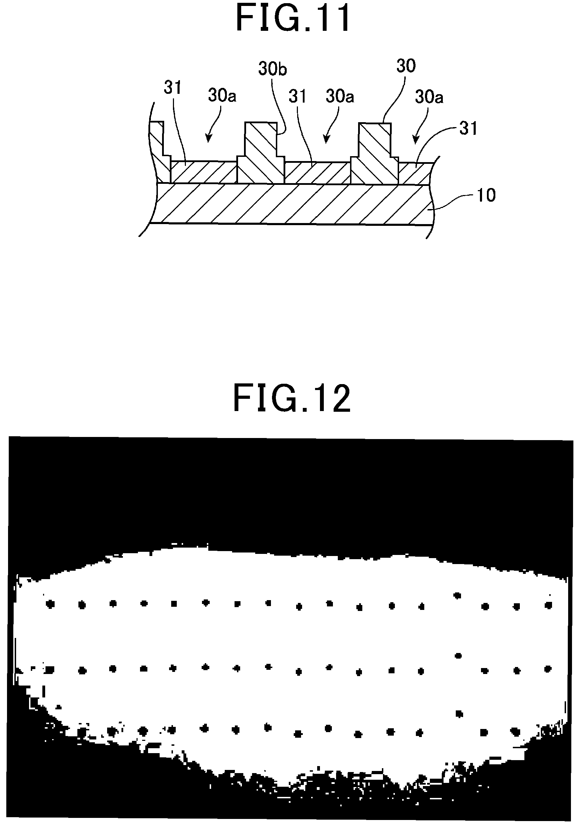

In the present embodiment, it is possible to form at least one layer of a layer between the cathode 15 and the light emitting layer 13, the light emitting layer 13, and a layer between the light emitting layer 13 and the anode 11 by an ink-jetting method. As illustrated in Fig. 11, a mask 30 is disposed on the substrate 10 and an inorganic layer 31 is printed by an ink-jetting method in a plurality of coating regions 30a that are spaces provided in the mask 30. In this case, to impart, for example, water repellency to each of sidewalls 30b of the mask 30, the surface of the sidewall 30b is subjected to fluorine treatment. This makes it possible to reduce the affinity of ink with the surface of the sidewall 30b and reduce defects such as depressions on the surface of the printed inorganic layer 31. It is possible to increase the degree of planarization of the surface of the inorganic layer 31.

The present embodiment adopts a top-emission type light emitting element and it is possible to appropriately improve the carrier balance of the inverted EL type light emitting element 3 illustrated in Figs. 4 and 6. Moreover, it is possible to form a layer (such as the electron transport layer 14 or the electron transport layer 14 and the electron injection layer 18) between the cathode 15 and the light emitting layer 13 and the light emitting layer 13 by coating. In addition, it is possible to form a layer (such as the hole transport layer 12 or the hole transport layer 12 and the hole injection layer 16) between the light emitting layer 13 and the anode 11 by vapor deposition or coating. This makes it possible to simplify the manufacturing steps of the light emitting element.

The display device 1 illustrated in Fig. 1 is only an example, and the red light emitting region 2a, the green light emitting region 2b, and the blue light emitting region 2c may be arranged in a different manner from that of Fig. 1. In addition, it is also possible to use a display device including only one light emitting region or two light emitting regions of the red light emitting region 2a, the green light emitting region 2b, and the blue light emitting region 2c.

It is possible in the display device including quantum dots to configure the quantum dots as both a point light source and a surface light source as in the present embodiment, and depending on a selected substrate, it is possible to realize even a curved light source or a flexible product.

In addition, the present embodiment makes it possible to develop characteristic products such as lighting having color-mixing properties equal to those of sunlight, which have been difficult to achieve in the past, eye-friendly lighting, and lighting optimized for plant factories.

In this way, display devices including quantum dots can be thin and light, and can be formed on curved surfaces, allowing for a high degree of freedom in placement. They can emit light from the entire surface, and can achieve natural light emission that is not dazzling even when viewed directly, and does not create shadows. Furthermore, a display device including quantum dots consumes less power and has a long life. For example, the display device including quantum dots according to the present embodiment is more excellent than an organic EL display device in color rendering/light emission, product life, and product price.

It is possible to use a PL emitter in parallel with an EL emitter for the display device including quantum dots according to the present embodiment. In addition, it is possible to realize a hybrid light emitting element in which an EL emitter and a PL emitter are stacked in the display device including quantum dots. For example, it is possible to change the emission wavelength using the quantum dots included in the PL emitter by overlaying the PL emitter on the surface of the EL emitter and using light emitted from excited quantum dots in the EL emitter. The EL emitter is structured to be stacked in the light emitting element described above. The PL emitter is, for example, a sheet-shaped wavelength conversion member having a plurality of quantum dots dispersed in resin. It is possible to achieve such a hybrid configuration by using quantum dots.

Additionally, to both increase the display device including quantum dots in area and reduce the manufacturing cost thereof, it is preferable in the present embodiment to use an ink-jet printing method, a spin coater method, or a dispenser method for a coating method.

It is noted that an Example has been described above in which a top-emission type light emitting element is used, but a bottom-emission type light emitting element may be used.

### Examples

Hereinafter, advantageous effects of the present invention will be described using Examples of the present invention. It is noted that embodiments of the present invention are not limited at all by the following Examples.

Each of the samples shown in Table 1 below was fabricated and the ink-jet droplet ejection performance was examined. It is noted that "Abs 10" refers to an absorbance of 10% with quantum dots dispersed and "Abs 20" refers to an absorbance of 20% with quantum dots dispersed.

**[Table 1]**

| sample | solvent | specific gravity | viscosity (mPa·s) | R.T. (°C) | number of ejections | mass (g) | mass/drop (g) | volume/drop (pL) | droplet ejectio n | adverse effects on EPDM | remarks |
|---|---|---|---|---|---|---|---|---|---|---|---|
| green QD Abs 10 | cyclododecene | 0.87 | | 23.5 | 10 million | 0.0407 | 4.07E-09 | 4.68 | Good | | |
| red QD Abs 20 | cyclododecene | 0.87 | | 25.6 | 10 million | 0.0397 | 3.97E-09 | 4.56 | Good | | |
| red QD Abs 20 | tetradecane | 0.77 | | 26.1 | 10 million | 0.0303 | 3.03E-09 | 3.94 | Good | CAP deformation | head clogging |
| green QD Abs 10 | tetradecane | | | | 10 million | aborted | | | Good | | |
| green QD Abs 10 | octadecene | 0.79 | 3.12 | 25.0 | 10 million | 0.0447 | 4.47E-09 | 5.66 | Good | | |
| red QD Abs 20 | octadecene | 0.79 | 2.97 | 26.7 | 10 million | 0.0449 | 4.49E-09 | 5.68 | Good | | advance head replacement |
| polyvinyl carbazole | dimethoxybenzene | 1.08 | | 26.7 | 10 million | 0.0579 | 5.79E-09 | 5.34 | Good | head was replaced twice | damper filter clogged by ethanol washing |
| polyvinyl carbazole | dimethoxybenzene : cyclohexylbenzene 1:1 | | | | | | | | Poor | failed to make droplets (two droplets) | |
| polyvinyl carbazole | dimethoxybenzene : cyclohexylbenzene 2:1 | 1.13 | | 26.5 | 10 million | 0.0527 | 5.27E-09 | 4.66 | Good | | |
| zinc oxide nanoparticle | IPA:propylene glycol 1:1 | | | | | | | | Poor | defective droplet ejection high viscosity? | |
| only solvent | tetradecane | 0.77 | 1.60 | 23.8 | 1 million | 0.0040 | 4.00E-09 | 4.60 | Good | | |
| | tetradecane | | | | 3 million | 0.0126 | 4.20E-09 | 4.83 | Good | | |
| | tetradecane | | | | | 0.0109 | 3.63E-09 | 4.18 | Good | | |
| | tetradecane | | | | 10 million | 0.0362 | 3.62E-09 | 4.16 | Good | | |
| only solvent | ODE (1-octadecene) | 0.79 | 3.10 | 23.0 | 10 million | 0.0385 | 3.85E-09 | 4.87 | Good | CAP deformation | |
| only solvent | decahydronaphthalene | 0.88 | 2.20 | 23.0 | 10 million | 0.0430 | 4.30E-09 | 4.89 | Good | Yes | |
| only solvent | cyclododecene | 0.87 | 4.20 | 23.0 | 10 million | 0.0514 | 5.14E-09 | 5.91 | Good | | |
| only solvent | ethylene glycol | 1.10 | 20.50 | 21.7 | Not possible | - | - | - | Poor | No | |
| only solvent | ethylene glycol 1 : IPA 1 | 0.94 | 7.40 | 25.0 | 10 million | 0.0500 | 5.00E-09 | 5.32 | Good | No | IPA specific gravity 0.78 |
| only solvent | ethylene glycol 3 : IPA 1 | 1.02 | 12.80 | 22.7 | 10 million | 0.0481 | 4.81E-09 | 4.72 | Good | No | |
| only solvent | ethylene glycol 3 : IPA 2 | 0.97 | 10.30 | 22.3 | 10 million | 0.0500 | 5.00E-09 | 5.15 | Good | No | |
| only solvent | phenylcyclohexane | 0.94 | 2.29 | 26.3 | 10 million | 0.0444 | 4.44E-09 | 4.72 | Good | | |
| only solvent | dichlorobenzene | 1.30 | 1.62 | 25.5 | Not possible | - | - | - | Poor | Yes | |
| only solvent | n-octane | 0.70 | unmeasurable | 24.3 | Not possible | - | - | - | Poor | CAP deformation | |

In Table 1, Good in the "droplet ejection" column shown refers to samples having appropriate droplet ejection and Poor refers to samples having defective droplet ejection.

In Table 1, the respective samples "red QD" and "green QD" are applied to light emitting layers. In addition, the respective samples "polyvinyl carbazole" are applied to hole injection layers. The sample "zinc oxide nanoparticle" is applied to an electron transport layer or an electron injection layer.

As shown in Table 1, it was found that IPA and propylene glycol were not preferable as solvents of zinc oxide nanoparticles and had to be changed. It is possible to apply as appropriate the solvents each shown as Good in the "droplet ejection" column shown in Table 1, but a hydrophilic solvent is preferable. For example, an alcohol-based solvent is applicable as the hydrophilic solvent.

Fig. 12 is a photograph showing ZnO_{X} applied by an ink-jetting method using ethoxyethanol and EG as a solvent at a ratio of 7:3. As illustrated in Fig. 12, a favorable coating state was obtained.

In addition, adverse effects on the EPDM (ethylene propylene diene rubber) inside the ink-jet head were also examined. As shown in Table 1, some samples underwent cap deformation and each had adverse effects on the EPDM. This shows that it is preferable to take even the effects on EPDM into consideration in a case where EPDM is used.

### (Experiment about Dependency of Quantum Dot on Shell Thickness)

In an experiment, quantum dots (green QD) of each of the samples shown in Table 1 were fabricated and the relationship between shell thickness and external quantum efficiency (External Quantum Efficiency: EQE) was examined using a display device including the light emitting element in Fig. 4A.

**[Table 2]**

| No. | Core | coating 1 | coating 2 | coating 3 | shell total (nm) | CV (%) | EQE (%) | QY (%) | FWH M | film thickness of QD layer |
|---|---|---|---|---|---|---|---|---|---|---|
| 1 | GC_A | I_A | II_A | III_A thick-1 | 1.8 | 17.2 | - | 86 | 38 | - |
| 2 | GC_A | I_A | II_A | III_A thick-2 | 2.4 | 18.8 | 4.5 | 80 | 39 | 37 |
| 3 | GC_A | I_A | II_A | III_A thick-3 | 3.1 | 15.2 | 0.9 | 43 | 39 | 23 |
| 4 | GC_A | I_A | II_A | - | 1.2 | 12.4 | 0.5 | 85 | 30 | 15 |
| 5 | GC_A | I_A | II_B | - | 1.8 | 21.9 | 2 | 88 | 32 | 25 |
| 6 | GC_A | I_A | II_C | - | 2 | 18.9 | 1.2 | 82 | 38 | 27 |
| 7 | GC_ A | - | - | - | reference | 10.3 | - | 13 | 30 | |
| 8 | GC_A | I_B thin | - | - | 0.2 | 16.8 | | 10 | 38 | |
| 9 | GC_A | I_B thin | - | - | 0.9 | 12.5 | | 91 | 34 | |
| 10 | GC_A | I_B | - | - | 1.3 | 12.9 | 6 | 86 | 33 | 36 |
| 11 | GC_A | I_B | II_D | - | 1.4 | 14.5 | 6 | 93 | 33 | 31 |

As shown in Table 2, shell thickness and EQE exhibited correlation. Although not limitative, the shell thickness was 0.1 nm or more and 4.0 nm or less, preferably 0.5 nm or more and 3.5 nm or less, more preferably 1.0 nm or more and 3.0 nm or less, and still more preferably 1.3 nm or more and 2.5 nm or less.

In addition, an examination of the relationship between the thickness of a quantum dot layer and EQE shows that a quantum dot layer which is thick to some degree tends to increase the EQE. Although the thickness of the quantum dot layer is not limited, the thickness of the quantum dot layer was 5 nm or more and 50 nm or less, preferably 10 nm or more and 45 nm or less, more preferably 15 nm or more and 40 nm or less, still more preferably 20 nm or more and 40 nm or less, yet still more preferably 25 nm or more and 40 nm or less.

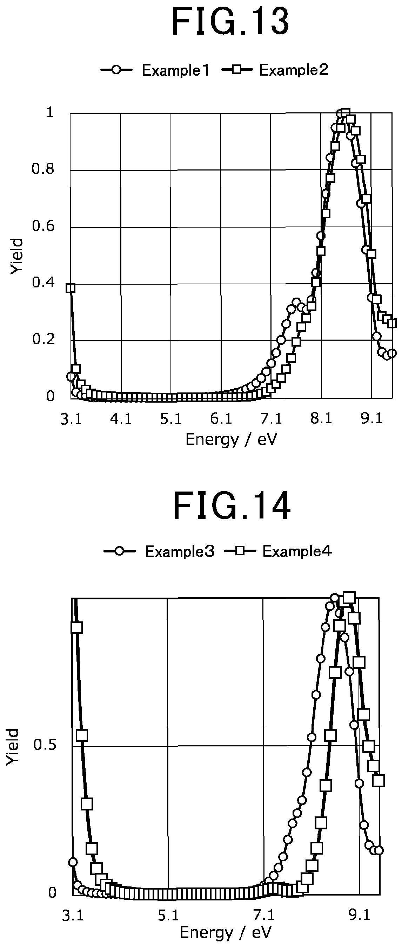

In addition, a PYS measurement of a Cd-based green quantum dot was made. The circles shown in Fig. 13 represent experimental data according to Example 1 using only a core, and the squares represent experimental data according to Example 2 using a core covered with a shell.

Photoelectron yield spectroscopy (PYS) allows ionization potential to be measured. For example, it is possible to measure ionization potential using devices such as AC-2 and AC-3 from RIKEN KEIKI Co., Ltd.

As illustrated in Fig. 13, it was found that Example 1 and Example 2 were different in onset energy. Example 1 had an onset energy of about 6.1 eV and Example 2 had an onset energy of about 7.1 eV.

Fig. 14 illustrates PYS measurement results of Example 3 and Example 4 including Cd-based green quantum dots different in shell thickness. Example 4 has greater thickness than that of Example 3. It was found that Example 3 and Example 4 were different in onset energy. Example 3 had an onset energy of about 7.1 eV and Example 4 had an onset energy of about 8.1 eV.

### (Experiment on Dependency of EQE on Current)

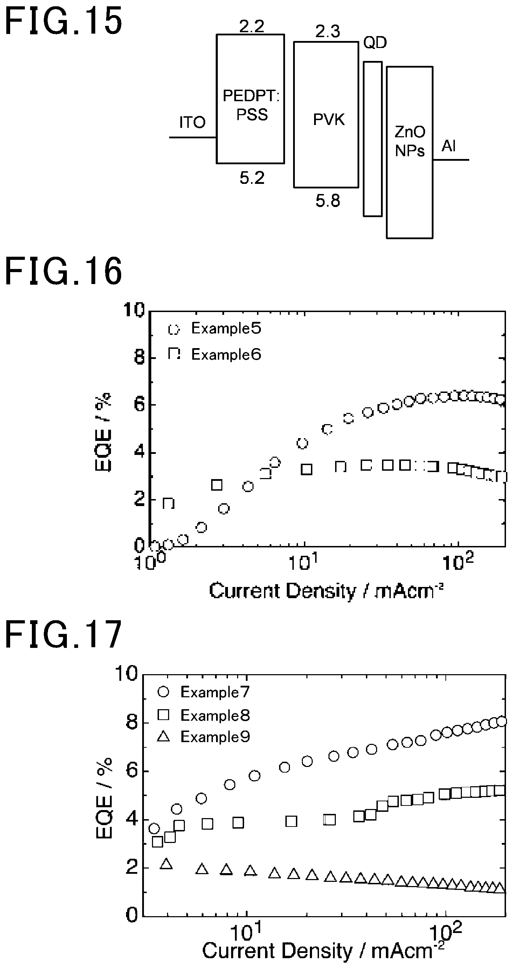

Fig. 15 is an energy level diagram of each of layers in a light emitting element used in an experiment. Fig. 16 is a graph illustrating the relationship between the current values of an EL emitter and a PL emitter each including a green quantum dot and EQE. In addition, Fig. 17 is a graph illustrating the relationships between the current values of an EL emitter and a PL emitter each including a red quantum dot and EQE and further illustrating the relationship between the current value of an EL emitter including a blue quantum dot and EQE. Example 5 and Example 6 illustrated in Fig. 16 are different in shell thickness. Example 5 has greater shell thickness than that of Example 6. In addition, in Fig. 17, Example 7 has the greatest shell thickness, and Example 8 and Example 9 have lower shell thickness in this order.

As illustrated in Figs. 16 and 17, increase in EQE was confirmed up to about 20 mA for an EL emitter and a PL emitter. Meanwhile, a red device underwent increase in EQE event at a current value of 20 mA or more. In addition, as illustrated in Figs. 16 and 17, EQE increased with increase in shell thickness.

### (Experiment about Synthesis of ZnO_{X})

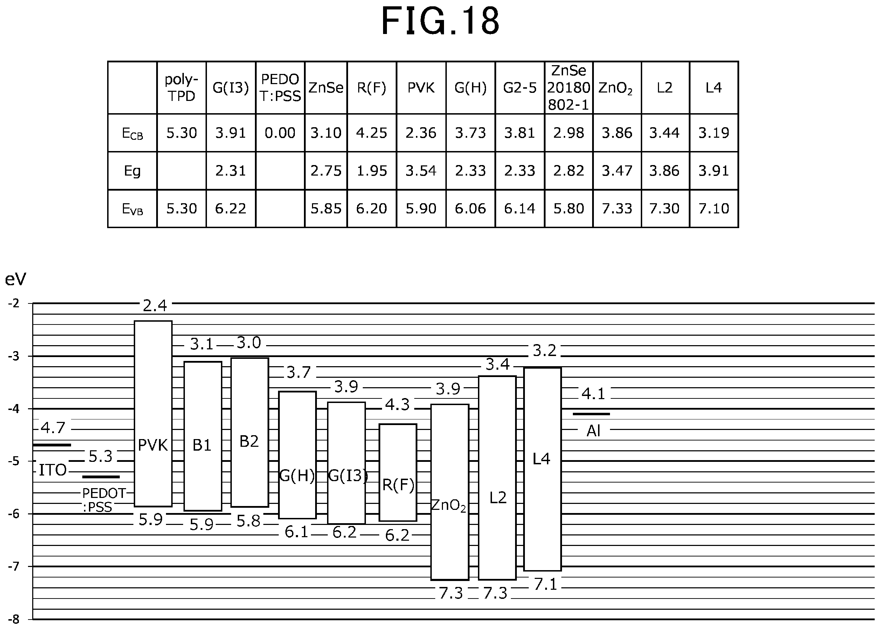

Fig. 18 includes a graph illustrating an energy band gap Eg, energy E_{CB} at the lower end of the conduction band, and energy E_{VB} at the upper end of the valence band of each of layers in a light emitting element used in the experiment and an energy level diagram of each of the layers. ZnO_{X}(Li) was used for L2 or L4 illustrated in Fig. 18. Here, Li may be doped or not. Although not limitative, X is about 0.8 to 1.2. As illustrated in Fig. 18, it was found that the use of ZnO_{X}(Li) for ZnO_{X} used for an electron injection layer and an electron transport layer (ETL) made it possible to widen the band gaps. It is estimated that ZnO_{X}(Li) has an effect of reducing particle size. PVK illustrated in Fig. 18 is used for a hole injection layer, B1, B2, G(H), G(I3), and R(F) are each used for a light emitting layer (EL layer), and ZnO_{X}, L2, and L4 are each used for an electron injection layer. It was found that it was possible to use ZnO_{X} for an electron injection layer in a case where B1 or B2 was used for a light emitting layer, but it was preferable to use L2 or L4 for an electron injection layer in a case where G(H), G(I3), or R(F) was used for a light emitting layer. L2 and L4 are ZnO_{X}(Li).

In particular, in a case where a light emitting layer (EL layer) having a low conduction band minimum is used, it is effective to apply ZnO_{X}(Li) to an electron injection layer or an electron transport layer.

Although not limitative, it is possible to generate ZnO_{X}(Li) by stirring a zinc acetate-ethanol solution at a predetermined temperature for a predetermined time and then mixing and stirring the LiOH·4H₂O-ethanol solution and performing centrifugation, washing, and the like.

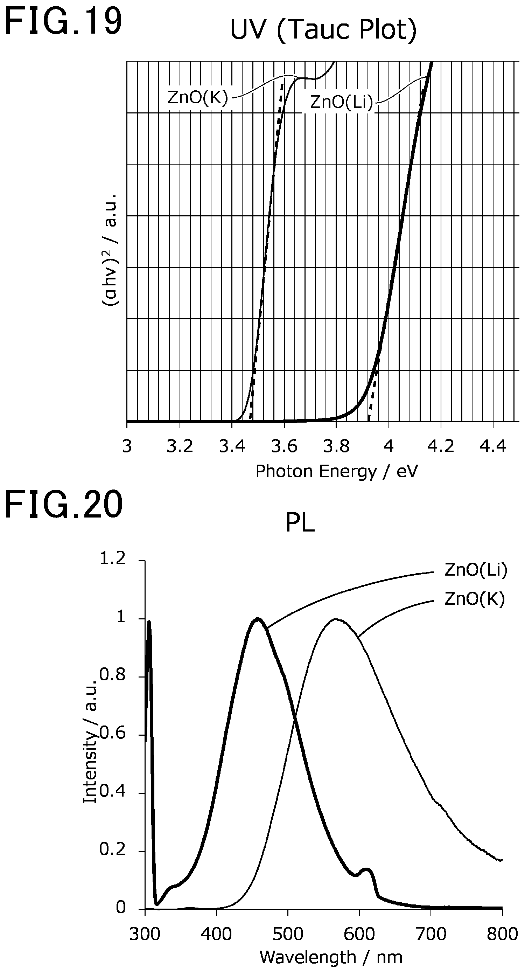

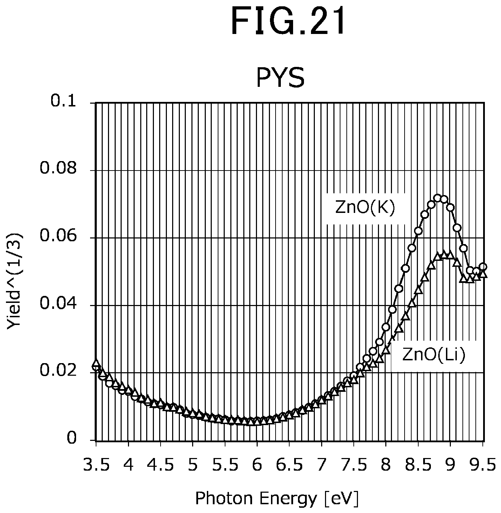

Figs. 19 to 21 illustrate UV (band gap) data, PL data, and PYS data of ZnO_{X}(Li) and ZnO_{X}(K) applied to an electron transport layer (ETL). ZnO_{X}(K) is generated using KOH catalytically and is not doped with K or Li. It was found that the UV data and the PL data were different between ZnO_{X}(Li) and ZnO_{X}(K). Meanwhile, the PYS shows that ZnO_{X}(Li) and ZnO_{X}(K) have almost no difference and have almost the same onset energy.

In this way, for an EL element including quantum dots, it is possible to propose ZnO_{X} having a controlled band gap due to various particle sizes for the electron injection / transport layer, or doped ZnO_{X} in which the defects and band gap are controlled by adding a dopant.

Nevertheless, in a case where it is not possible to achieve the balance of the recombination of electrons and holes that generates light, it is preferable to impart a function of blocking holes for balance adjustment by interposing a thin insulating layer between the EL layer and the electron injection layer or bonding ZnO_{X} and molecules. Here, the bonding layer refers to bonding, for example, ZnOₓ and T2T (2,4,6-tris(biphenyl-3-yl)-1,3,5-triazine). Although not limitative, X is about 0.8 to 1.2.

In addition, it has been known that ozone treatment or the like allows ZnOₓ to have a function of serving as the hole injection/transport layer in addition to the electron injection/transport layer. That is, it was found that ozone treatment on ZnOₓ increased the hole transport ability.

In the present embodiment, the electron transport layer is formed using ZnO, MgZnO, or SnO. Hereinafter, synthesis flows of these metal oxides will be described.

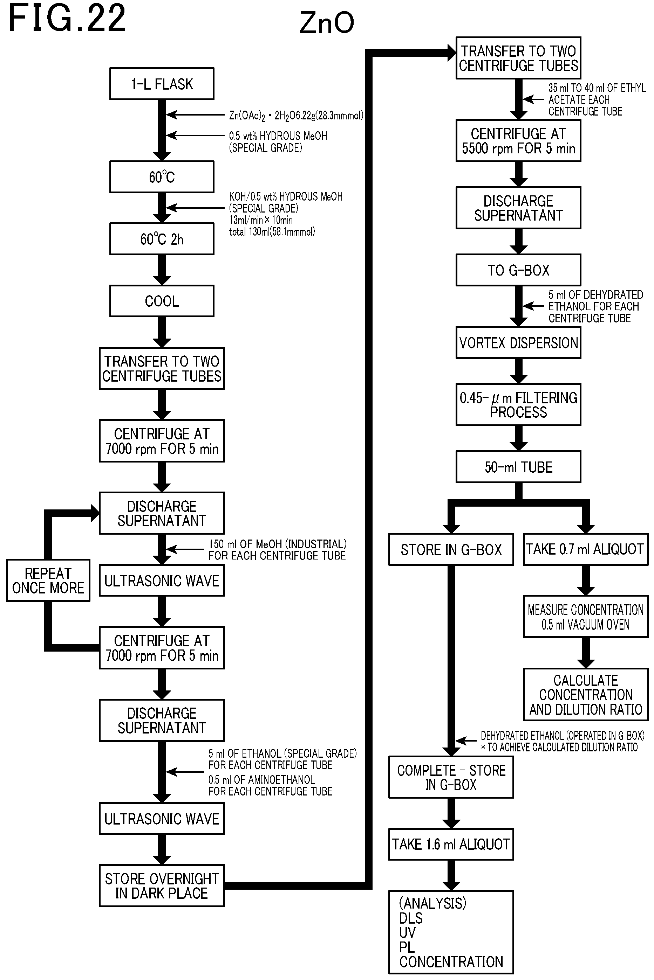

Fig. 22 is a synthesis flow of ZnO. As illustrated in Fig. 22, Zn(OAc)₂·2H₂O (6.22 g, 28.3 mmol) and 0.5 wt% hydrous methanol (198.8 g, 251 ml) were mixed in a flask and the temperature thereof was raised to 60°C.

Next, KOH/0.5 wt% hydrous methanol was added to the flask at a rate of 13 ml per minute and this addition was continued for ten minutes. A temperature of 60°C was then maintained for two hours.

Subsequently, the contents of the flask were transferred to two centrifuge tubes after being cooled, and were centrifuged under conditions of 7000 rpm for five minutes. Subsequently, the supernatant liquids of the respective centrifuge tubes were discharged and the centrifuge tubes were subjected to ultrasonic waves, after which they were centrifuged again under conditions of 7000 rpm for five minutes. The step of discharging the supernatant liquids → ultrasonic wave step → centrifugation step was repeated once more.

After that, the steps of discharging the supernatant liquids → the ultrasonic wave step were performed. Ethanol (5 ml) and aminoethanol (0.5 ml) were added to each of the centrifuge tubes between the step of discharging the supernatant liquids and the ultrasonic wave step. The centrifuge tubes were then stored overnight in a dark place.

Next, the contents of the centrifuge tubes were transferred to other two centrifuge tubes and about 35 to 40 ml of ethyl acetate was then added to each of the centrifuge tubes, which were then centrifuged under conditions of 5500 rpm for five minutes. The supernatant liquids of the respective centrifuge tubes were then discharged and each of the centrifuge tubes was transferred to a G-BOX and dispersed using a vortex mixer.

Next, the contents of each of the centrifuge tubes were transferred to a 50-ml tube through a 0.54-µm filter. A 0.7 ml aliquot was taken therefrom and the remainder was stored in the G-BOX. A concentration measurement was made using the 0.7 ml aliquot, to calculate the concentration and the dilution ratio. An adjustment was made using dehydrated ethanol in the G-BOX on the basis of the calculation to achieve the calculated dilution ratio. The completed G-BOX was then stored. A 1.6 ml aliquot was taken from this completed G-BOX and the DLS, the UV value, the PL value, and the concentration were analyzed.

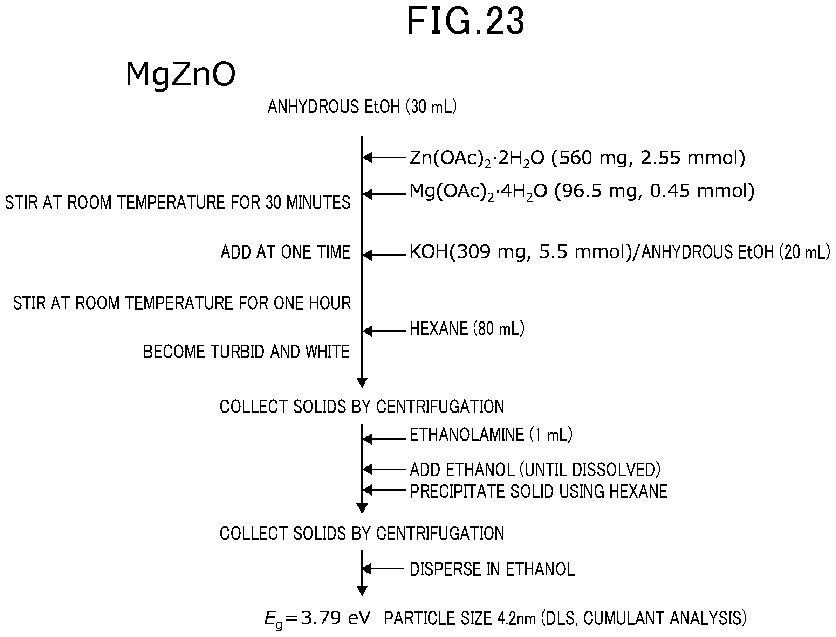

Fig. 23 is a synthesis flow of MgZnO. First, as illustrated in Fig. 23, anhydrous ethanol (30 mL) was prepared. Zn(OAc)₂·2H₂O (560 mg, 2.55 mmol) and Mg (OAc)₂·4H₂O (96.5 mg, 0.45 mmol) were added to this and stirring was performed at room temperature for 30 minutes. Subsequently, KOH (309 mg, 5.5 mmol)/anhydrous ethanol (20 mL) was added. This was then stirred at room temperature for one hour. Subsequently, hexane (80 mL) was added. This caused the mixed solution to become turbid and white. Ethanolamine (1 mL) was added to this mixed solution until dissolved. Hexane was further added to precipitate solids and dispersion was performed using ethanol. This offered MgZnO having a particle size of about 4.2 nm. Band gap energy E_{g} of the MgZnO was 3.79 eV.

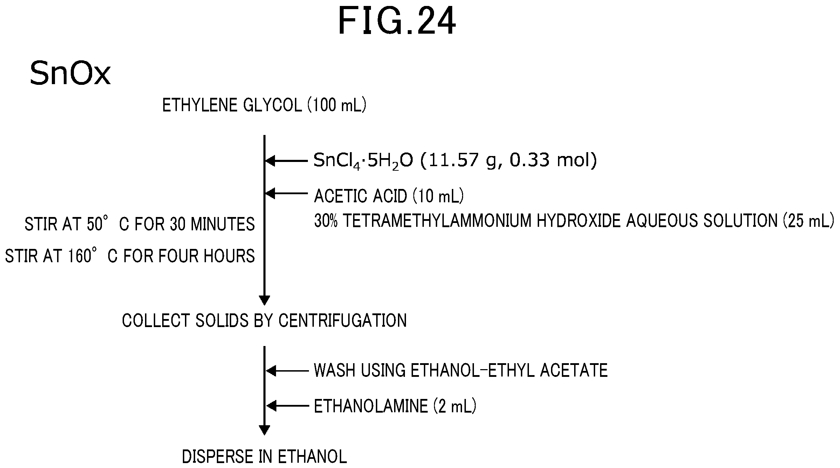

Fig. 24 is a synthesis flow of SnOx. As illustrated in Fig. 24, ethylene glycol (100 mL) was prepared. SnCl₄·5H₂O (11.57 g, 0.33 mol), acetic acid (10 mL), and a 30% tetramethylammonium hydroxide aqueous solution (25 mL) were mixed therewith and stirring was performed at 50°C for 30 minutes. Subsequently, the temperature was increased to 160°C and stirring was performed for four hours.

Subsequently, washing was performed using ethanol-ethyl acetate, 2 ml of ethanolamine was added, and dispersion was performed using ethanol.

In the present embodiment, the hole transport layer 12 is formed using NiO or MoO. Hereinafter, synthesis flows of these metal oxides will be described.

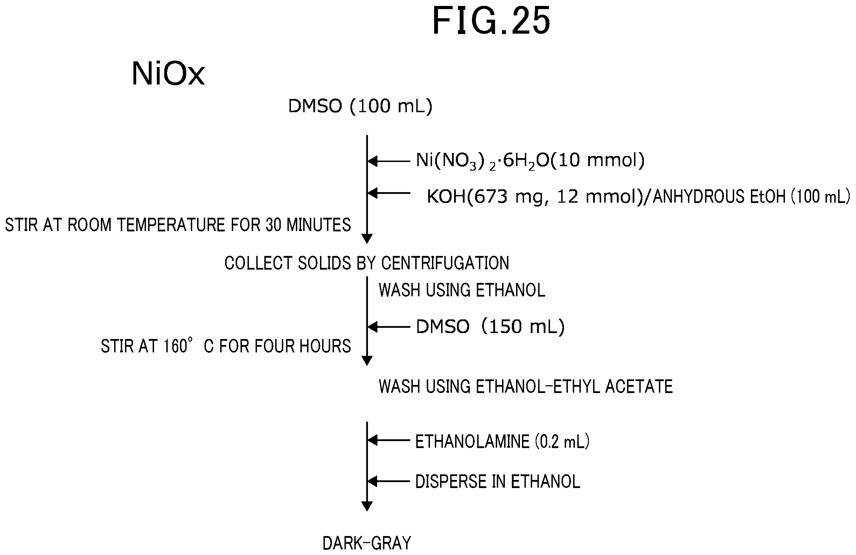

Fig. 25 is a synthesis flow of NiOx. As illustrated in Fig. 25, DMSO (100 mL) was prepared. Ni(NO₃)₂·6H₂O (10 mmol) and KOH (673 mg, 12 mmol)/anhydrous ethanol (100 mL) were mixed therewith and stirring was performed at room temperature for 30 minutes. Subsequently, after washing was performed using ethanol, DMSO (150 mL) was mixed and stirring was performed at a temperature of 160°C for four hours. Next, washing was performed using ethanol-ethyl acetate, ethanolamine (0.2 mL) was added, and dispersion was performed using ethanol. Dark-gray precipitates were obtained.

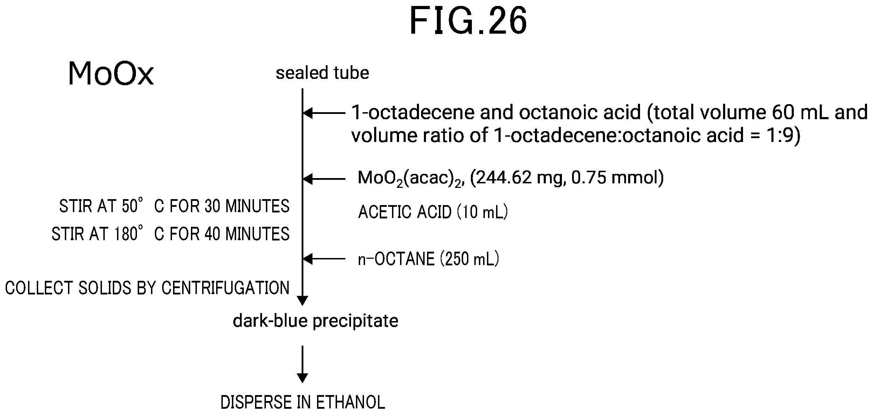

Fig. 26 is a synthesis flow of MoOx. 1-octadecene and octanoic acid (a total volume of 60 mL, 1-octadecene and octanoic acid at a volume ratio of 1:9), MoO₂(acac)₂ (244.62 mg, 0.75 mmol), and acetic acid (10 mL) were mixed in a sealed tube and stirring was performed at 50°C for 30 minutes. Subsequently, the temperature was increased to 180°C and stirring was performed for 40 minutes. n-octane (250 mL) was added to obtain a dark-blue precipitate. The precipitate was dispersed in ethanol.

The synthesis flows according to the present embodiment make it possible to obtain metal oxides having no oxidation deficiency. The use of the electron transport layer and the hole transport layer according to the present embodiment effectively allows the absorption edge of the infrared region to be steeper.

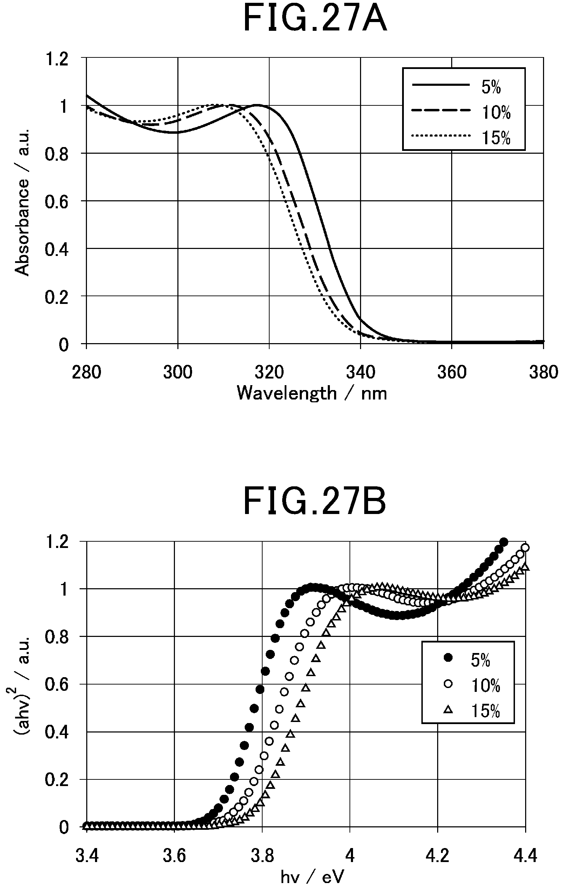

Fig. 27A is a graph illustrating the UV spectrum and Fig. 27B is a graph illustrating band gap energy. The Mg doping amount of MgZnO was changed in an experiment. It is noted that the MgZnO used in the experiment was as-synthesized MgZnO dispersed in DEGME. As illustrated in Fig. 27 and shown in Table 3, it was found that the band gap energy E_{g} increased with increase in the Mg doping amount.

**[Table 3]**

| dope | Std (0%) | Mg 5% | Mg 10% | Mg 15% |
|---|---|---|---|---|
| E_{g}/eV | 3.48 | 3.71 | 3.75 | 3.79 |

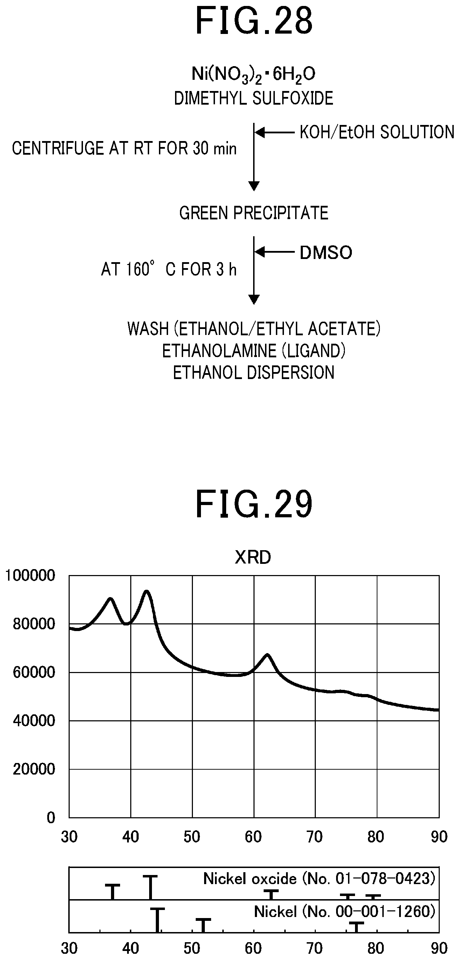

Fig. 28 is a synthesis flow of NiO. It is noted that a synthesis flow different from that of Fig. 25 is illustrated. That is, as illustrated in Fig. 28, Ni(NO₃)₂·6H₂O, a dimethyl sulfoxide, and a KOH/anhydrous ethanol solution were mixed and stirring was performed at room temperature for 30 minutes. This yielded a green precipitate. This was mixed with DMSO, maintained at a temperature of 160°C for three hours, and washed using ethanol/ethyl acetate. After that, ethanolamine was added and dispersion was performed using ethanol.

Fig. 29 illustrates the XRD for NiO. The NiO used in an experiment was obtained in accordance with the synthesis flow of Fig. 28. As illustrated in Fig. 29, it was possible to observe NiO. Meanwhile, Ni was not observed and it was found that appropriate synthesis was performed.

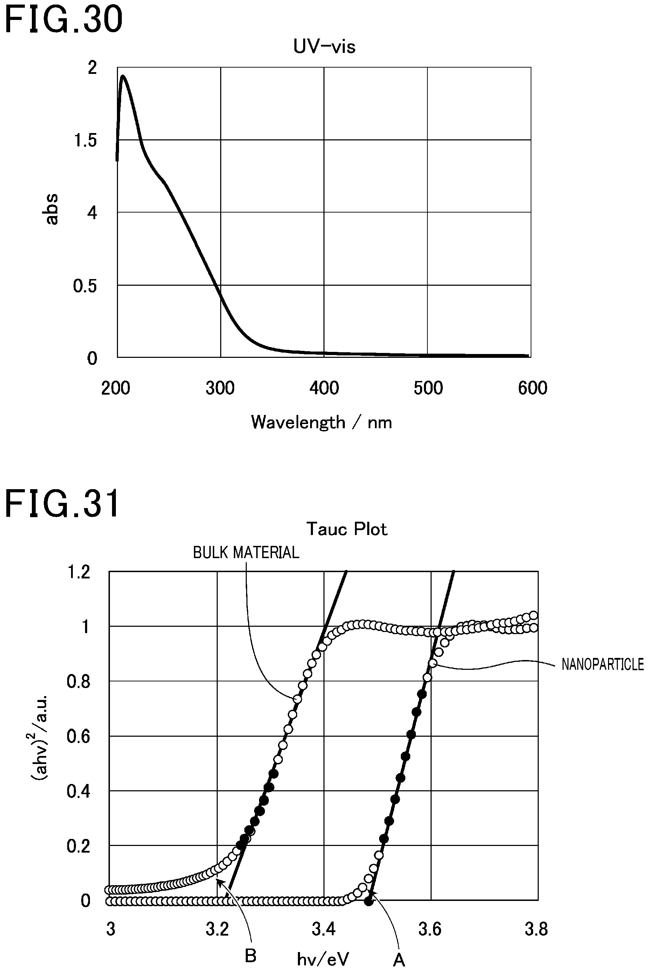

Fig. 30 illustrates the UV spectrum of NiO and Fig. 31 is a graph (Tauc plot) illustrating band gap energy.

As illustrated in Fig. 31, it was found that the slope of the Tauc plot (Tauc Plot) at the absorption edge is greater than that of the bulk material. It was found that this allowed the absorption edge to be steeper. As illustrated in Fig. 31, it was found that the nanoparticles had a smaller tail section for the rise of the Tauc plot than that of the bulk material and the Tauc plot rose more sharply than that of the bulk material. All the electron transport materials according to the present Example are semiconductors. The slope of the Tauc plot of each of all the electron transport materials was thus greater than that of the bulk material.

In addition, as illustrated in Fig. 31, it was found that, among regions A and B surrounded by the tangent lines each indicating a slope, the plot curves, and the horizontal axis, the region A for the nanoparticles was smaller than the region B for the bulk material. Oxidation deficiency grows smaller with decrease in this region. It was thus proved that the nanoparticles were less than the bulk material in oxidation deficiency.

### <Ni Valence of NiO>

A calibration curve between the onset position of the XANES spectrum and Ni valence was created using standard samples (NiO: divalent and LiNiO₂: trivalent) the valence of each of which had been known. In an experiment, BL08W was used as a beam line and a transmission method was used as a measurement method.

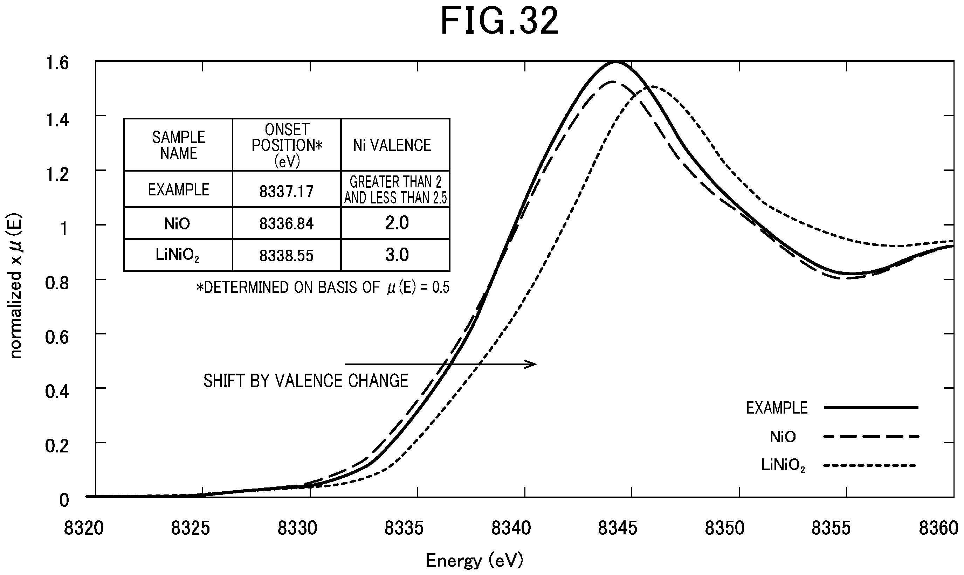

Subsequently, the Ni valence was evaluated using the XANES spectrum of NiO created by a synthesis method according to the present Example. An experiment result thereof is illustrated in Fig. 32.

As illustrated in Fig. 32, it was found that the XANES spectrum was shifted by a valence change. The XANES spectrum according to the Example was then present between the divalent NiO and the trivalent LiNiO₂. The Ni valence of the NiO according to the Example was therefore between 2 and 3 and was closer to the divalent NiO. It was thus found that the Ni valence according to the Example was greater than 2 and less than 2.5. Preferably, the Ni valence according to the Example was 2.1 or more and 2.4 or less. It is noted that the Ni valence is predicted to be about 2.2 in the Example of Fig. 32. This proved that the NiO according to the present Example was a hole carrier.

In addition, a dispersion liquid of the metal oxide used for the electron transport layer according to the present Example had a polydispersity index of less than 0.1 in a DLS measurement. Dynamic light scattering (DLS) is applied to nanoparticles floating and dispersed in the liquid. The DLS measurement is a method for calculating the particle size by measuring the diffusion speed of nanoparticles moving in Brownian motion.

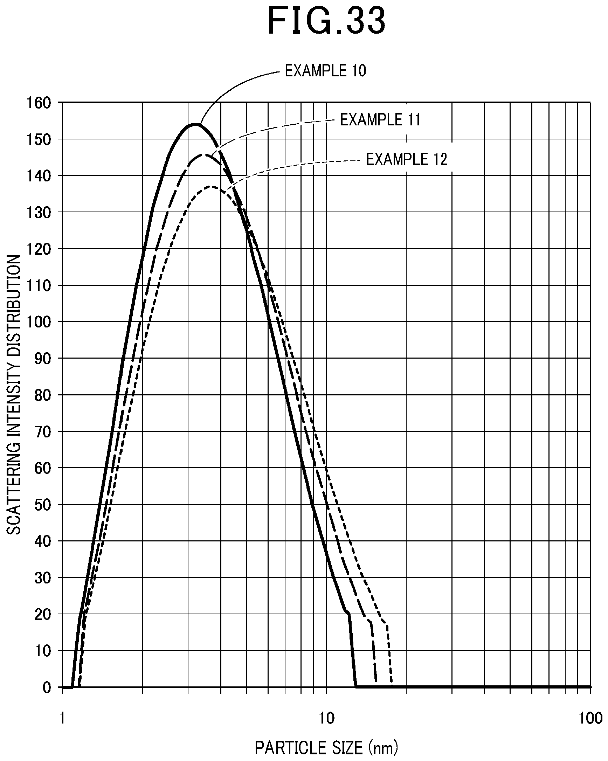

A polydispersity index (PDI) is used to express the width of particle size distribution. In an experiment, ZnO particles were fabricated as the metal oxide used for the electron transport layer. Fig. 33 is a graph illustrating the relationships between particle size and scattering intensity distribution in respective Examples. As shown in Table 4, Example 10 to Example 12 each had a polydispersity index of less than 0.1. This shows that all the measured particles had substantially the same particle size in the respective Examples.

**[Table 4]**

| | sample | number of repetitions | pH | average particle size (nm) | polydispersity index | Mean .(nm) | D (10%) (nm) | D (50%) (nm) | D (90%) (nm) |
|---|---|---|---|---|---|---|---|---|---|
| Example 10 | ZnO(K) | 1 | NA | 4.6 | 0.014 | 4.1 | 1.7 | 3.4 | 7.2 |
| Example 11 | ZnO(K) | 1 | NA | 4.4 | 0.007 | 4.5 | 1.8 | 3.7 | 8.2 |
| Example 12 | ZnO(K) | 1 | NA | 4.3 | 0.007 | 4.9 | 1.8 | 3.9 | 9.2 |
| | average value | | | 4.4 | 0.009 | 4.5 | 1.8 | 3.7 | 8.2 |

A metal oxide such as ZnO or NiO is present in the display device as a film. In the present embodiment, a polydispersity index of less than 0.1 increases dispersibility as described above and it is possible to define the performance of the film as surface roughness after film formation.

That is, the film surface roughness Ra (arithmetic average roughness) is preferably less than 1.0 nm. It is possible to analyze the surface roughness (Ra) using AFM measurement or the like.

### [Industrial Applicability]

The present invention makes it possible to apply a light emitting element including quantum dots to a display device and obtain excellent light emission characteristics.

This application is based on Japanese Patent Application No. 2023-170557 filed on September 29, 2023. The entire contents thereof are incorporated herein.

## Claims

1. A display device comprising a display region, wherein
the display region includes a light emitting element, in which a first electrode, a light emitting layer, a second electrode, an electron transport layer or a hole transport layer that is formed between the first electrode and the light emitting layer, and a hole transport layer or an electron transport layer that is formed between the second electrode and the light emitting layer are stacked,
the electron transport layer contains at least one of ZnO, MgZnO and SnO, and
the hole transport layer or a hole injection layer contains at least one of NiO and MoO.

2. The display device according to claim 1, wherein
oxidation deficiency of metal oxides constituting the electron transport layer and the hole transport layer is less than oxidation deficiency of a bulk material.

3. The display device according to claim 1, wherein
the light emitting layer contains a quantum dot, the quantum dot includes an organic ligand on a surface, and the organic ligand includes 3-mercaptopropionic acid.

4. The display device according to claim 1, wherein
the light emitting layer contains a quantum dot, the quantum dot includes a ligand on a surface, and the ligand includes two or more and five or less carbon atoms.

5. A nanoparticle material that is a material which is used for an electron transport layer included in the display device according to claim 1, wherein
a slope of a Tauc plot of the material at an absorption edge is greater than a slope of a Tauc plot of a bulk material at an absorption edge.

6. A dispersion liquid of the material according to claim 5, wherein
the dispersion liquid has a polydispersity index of less than 0.1 in a DLS measurement.

7. A method for manufacturing the display device according to claim 1, the method comprising, in a step of forming the light emitting layer, replacing a ligand after applying a composition containing a quantum dot.

8. The method for manufacturing the display device according to claim 7, wherein,
when the quantum dot is synthesized by solution phase synthesis, the quantum dot is synthesized as the quantum dot having a long ligand and the long ligand is then replaced with a short ligand before or after a composition containing the quantum dot is applied.
